**Europäisches Patentamt**

**European Patent Office**

**Office européen des brevets**

(19)

(11) Veröffentlichungsnummer: **0 264 700 B1**

(12) **EUROPÄISCHE PATENTSCHRIFT**

(45) Veröffentlichungstag der Patentschrift: 08.05.91

(51) Int. Cl.⁵: **H01L 21/304, B24B 9/06**

(21) Anmeldenummer: 87114481.2

(22) Anmeldetag: 05.10.87

(54) **Verfahren zum Anbringen einer umlaufenden Hohlkehle am Rand einer Halbleiterscheibe eines Leistungshalbleiter-Bauelements.**

(30) Priorität: 22.10.86 CH 4212/86

(43) Veröffentlichungstag der Anmeldung:
27.04.88 Patentblatt 88/17

(45) Bekanntmachung des Hinweises auf die
Patenterteilung:
08.05.91 Patentblatt 91/19

(84) Benannte Vertragsstaaten:
**CH DE FR GB IT LI SE**

(56) Entgegenhaltungen:
**CH-A- 489 116
DE-A- 1 764 326
DE-A- 2 354 854
DE-A- 3 026 272
US-A- 4 227 347**

(73) Patentinhaber: **BBC Brown Boveri Aktiengesellschaft**

**CH-5401 Baden(CH)**

(72) Erfinder: **Dlouhy, Jiri
Haldenstrasse 410
CH-5506 Mägenwil(CH)**
Erfinder: **Kuhn, Otto
Weierstrasse 260
CH-Lupfig(CH)**
Erfinder: **Rüegg, Andreas, Dr.
Sandsteig 23
CH-5412 Gebenstorf(CH)**

EP 0 264 700 B1

**Beschreibung**

Technisches Gebiet

Die Erfindung bezieht sich auf die Herstellung von Leistungsschalterbauelementen. Sie betrifft insbesondere ein Verfahren zum Anbringen einer umlaufenden Hohlkehle am Rand einer Halbleiterscheibe eines Leistungshalbleiter-Bauelements, bei welchem die Hohlkehle mechanisch in die Halbleiterscheibe eingeschliffen wird.

Stand der Technik

In der Technik der Leistungshalbleiter-Bauelemente ist es seit langem bekannt, als Randkontur für die Halbleiterscheiben von hochsperrenden, symmetrischen Thyristoren eine umlaufende Hohlkehle vorzusehen.

Für die in der Serienproduktion einsetzbare Herstellung von solchen Hohlkehlen sind die unterschiedlichsten Verfahren vorgeschlagen worden. So ist es z.B. aus der DE-B- 1 439 215 bekannt, die Hohlkehle mittels eines geeigneten Säure- oder Sandstrahls in die Halbleiterscheibe einzuätzen oder einzuschleifen. In derselben Druckschrift ist ohne nähere Angaben noch darauf hingewiesen worden, dass die Hohlkehle auch mit rein mechanischen Mitteln wie Schmirgelscheiben oder dergleichen erzeugt werden könne.

Solche mechanischen Mittel und ihr Einsatz sind eingehender in der DE-A- 1 764 326 beschrieben, wo zum Herausarbeiten der Hohlkehle in aufeinanderfolgenden Schleifvorgängen Schleifdrähte oder Schleifbleche verschiedener, abgestufter Dicke verwendet werden.

In der Praxis hat sich jedoch gezeigt, dass gerade das mechanische Abtragen des Halbleitermaterials entweder sehr komplizierte Bearbeitungsvorgänge (wie in der DE-A- 1 764 326 dargestellt) erfordert oder aber nicht zu brauchbaren Ergebnissen führt, weil die Halbleiterscheibe gegenüber der mechanischen Einwirkung sehr empfindlich ist.

Es ist daher in der Vergangenheit bei der serienmässigen Herstellung von Leistungshalbleiter-Bauelementen mit hohlkehlenförmiger Randkontur ausschliesslich auf das erwähnte Sandstrahlverfahren zurückgegriffen worden, welches jedoch, gerade bei zunehmender Dicke der Halbleiterscheiben, erhebliche Nachteile aufweist:

- Die Bearbeitungszeit nimmt mit zunehmender Scheibendicke sehr stark zu. Schon bei einer Dicke von 1100 $\mu$m liegt sie an der Grenze des Sinnvollen;
- der beim Sandstrahlen notwendige Schutzlack wird mit steigender Zeit des Absandens immer mehr abgetragen. Ab etwa 1300 $\mu$m Scheibendicke reichen auch 2 Schutzlackschichten nicht mehr aus, sodass Thyristoren mit 8-10 kV Sperrspannung nicht mehr auf diese Weise bearbeitet werden können; und
- die Toleranzen des Sandstrahlprozesses erlauben keine exakt reproduzierbare Lage und Form der Hohlkehle.

Aus dem Gesagten geht hervor, dass es wünschenswert ist, für die Hohlkehlen-Bearbeitung den bisher verwendeten Sandstrahlprozess durch einen für die Serienfertigung geeigneten mechanischen Prozess abzulösen, der die Nachteile bisher bekannter mechanischer Prozesse vermeidet.

Darstellung der Erfindung

Aufgabe der vorliegenden Erfindung ist es daher, ein mechanisches Verfahren zur Herstellung einer Hohlkehle zu schaffen, dass vergleichsweise einfach durchzuführen ist und in der Serienfertigung eine hohe Ausbeute an funktionstüchtigen Bauelementen ermöglicht.

Die Aufgabe wird bei einem Verfahren der eingangs genannten Art dadurch gelöst, dass

(a) der Rand der Halbleiterscheibe zunächst plan geschliffen wird, wobei in einem ersten Schritt mit einer Grobschleifscheibe überflüssiges Halbleitermaterial abgetragen, und in einem zweiten Schritt mit einer Feinschleifscheibe die entstandene Randfläche nachgearbeitet wird;

(b) die Hohlkehle dann mittels einer am Rand entsprechend konturierten Profilschleifscheibe in einem Arbeitsgang eingeschliffen wird;

(c) für alle Schleifvorgänge Diamantschleifscheiben verwendet werden;

(d) bei der Grobschleifscheibe und der Profilschleifscheibe die Diamantkörner in einer Metallbindung vorliegen; und

2

(e) bei der Feinschleifscheibe die Diamantkörner in einer Kunststoffbindung eingelagert sind.

Durch die erfindungsgemässe Auftrennung des Konturierungsvorganges in die beiden Schritte des Planschleifens und des Einschleifens der Hohlkehle wird erreicht, dass die sehr empfindlichen Randpartien der Hohlkehle für sich gesondert behandelt werden können, während die eigentliche Hohlkehle in einem vereinfachten Arbeitsgang in die Halbleiterscheibe eingebracht werden kann.

Gemäss der Erfindung wird der Vorgang des Planschleifens seinerseits in zwei Schritte unterteilt, wobei in einem ersten Schritt mittels einer Grobschleifscheibe (mit Diamantkörnern in Metallbindung) überflüssiges Halbleitermaterial schnell abgetragen, und in einem zweiten Schritt mittels einer Feinschleifscheibe (mit Diamantkörnern in Kunststoffbindung) die entstandene Randfläche nachgearbeitet wird.

Ein bevorzugtes Ausführungsbeispiel der Erfindung zeichnet sich dadurch aus, dass
(a) die Belegungsdichte mit Diamantkörnern bei allen Schleifscheiben etwa 4,4 Karat/cm$^3$ beträgt; und
(b) die Grobschleifscheibe (1) Diamantkörner mit einem mittleren Durchmesser von 25 $\mu$m, die Feinschleifscheibe (2) Diamantkörner mit einem mittleren Durchmesser von 20 $\mu$m und die Profilschleifscheibe (3) Diamantkörner mit einem mittleren Durchmesser von 16 $\mu$m enthält.

Weitere Ausführungsbeispiele ergeben sich aus den Unteransprüchen.

Kurze Beschreibung der Zeichnungen

Die Erfindung soll nachfolgend im Zusammenhang mit der Zeichnung anhand von Ausführungsbeispielen näher erläutert werden. Es zeigen

Fig. 1    schematisch den Vorgang des Grobschleifens;
Fig. 2    entsprechend den Vorgang des Feinschleifens;
Fig. 3    in gleicher Weise den Vorgang des Hohlkehlen- oder Profilschleifens; und
Fig. 4    im Ausschnitt den Querschnitt durch eine Halbleiterscheibe mit Hohlkehle.

Wege zur Ausführung der Erfindung

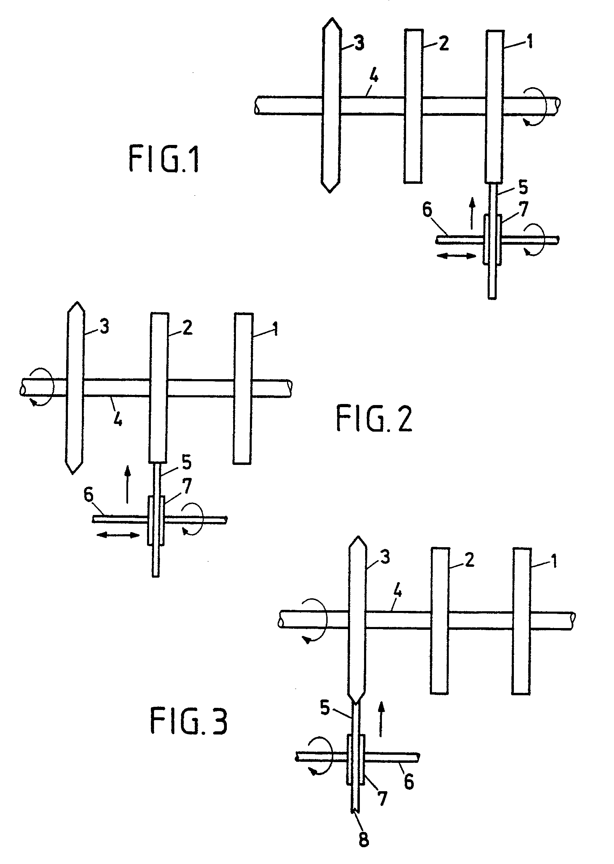

Die Figuren 1-3 zeigen in der entsprechenden Reihenfolge schematisch die einzelnen Schritte gemäss einem bevorzugten Ausführungsbeispiel des erfindungsgemässen Verfahrens.

Ausgangspunkt ist eine fertig diffundierte, im wesentlichen runde Halbleiterscheibe 5, die üblicherweise einen Durchmesser von mehreren cm und eine Dicke in der Grössenordnung um 1000 $\mu$m aufweist. Bei der Herstellung der inneren Struktur des Bauelements wird an der Halbleiterscheibe 5 ein Rand belassen, der bei Fertigstellung des Bauelementes entfernt werden muss.

Die Entfernung dieses Rands geschieht in einem ersten Grobschleifprozess mit einer Grobschleifscheibe 1, die bevorzugt zusammen mit einer Feinschleifscheibe 2 und einer Profilschleifscheibe 3 auf einer gemeinsamen Schleifscheibenachse 4 angeordnet ist (Fig. 1) und in der durch den Drehpfeil angegebenen Richtung rotiert.

Die Halbleiterscheibe 5 ist in einer Halterung 7 auf einer parallel zur Schleifscheibenachse 4 verlaufenden Halbleiterscheibenachse 6 drehbar gelagert und wird mit ihrer Stirnseite gegen die Stirnfläche der Grobschleifscheibe 1 mit einer Vorschubgeschwindigkeit von vorzugsweise 3mm/min geschoben.

Die Grobschleifscheibe 1 dreht sich während des Schleifvorgangs mit einer solchen Geschwindigkeit um die Schleifscheibenachse, dass die Schnittgeschwindigkeit, d.h. ihre Umfangsgeschwindigkeit etwa 35 m/s beträgt.

Um ein möglichst gleichmässiges Abtragen des Halbleitermaterials zu gewährleisten, wird einerseits während des Schleifvorgangs (in Fig. 1 durch den Doppelpfeil angedeutet) die Halbleiterscheibe 5 parallel zur Rotationsachse, d.h. zur Halbleiterscheibenachse 6 bzw. Schleifscheibenachse 4 bis über den Rand der Grobschleifscheibe 1 hinaus oszillatorisch hin-und herbewegt. Andererseits rotiert die Halbleiterscheibe 5 bei dem Schleifvorgang zu der Grobschleifscheibe 1 gegenläufig, und zwar vorzugsweise mit einer Rotation von 80 Umdrehungen/min.

Als Kühlflüssigkeit für alle hier beschriebenen Schleifvorgänge hat sich Wasser bewährt, dem zum Schutz der Schleifeinrichtungen ein Rostschutzmittel zugesetzt worden ist.

Da es beim Grobschleifen zunächst hauptsächlich auf einen schnellen Materialabtrag bei guten Standzeiten für die Grobschleifscheibe 1 ankommt, wird als Grobschleifscheibe bevorzugt eine Diamantschleifscheibe verwendet, bei der Diamantkörner mit einem mittleren Durchmesser von 25 $\mu$m in einer Metallbindung vorliegen.

Nachdem i m Grobschleifvorgang gemäss Fig. 1 die überflüssigen Randschichten der Halbleiterscheibe

in kurzer Zeit weitgehend abgetragen worden sind, folgt ein Feinschleifvorgang mit der Feinschleifscheibe 2 gemäss Fig. 2.

Beim Feinschleifen werden für die Halbleiterscheibe 5 und die Feinschleifscheibe 2 dieselben Rotationsgeschwindigkeiten, Schnittgeschwindigkeiten und oszillatorischen Bewegungen vorgesehen wie beim Grobschleifen. Unterschiedlich ist dagegen die Vorschubgeschwindigkeit, die hier mit 1 mm/min deutlich geringer ausfällt.

Dies hängt unter Anderem damit zusammen, dass die Feinschleifscheibe 2 andere Eigenschaften besitzt, als die Grobschleifscheibe 1: Zwar handelt es sich auch hier um eine Diamantschleifscheibe. Jedoch werden Diamantkörner mit einem mittleren Durchmesser von 20 $\mu$m verwendet. Wichtiger ist jedoch der Unterschied, dass die Diamantkörner bei der Feinschleifscheibe 2 in einer weicheren Kunststoffbindung vorliegen, um Ausbrüche am Rand der Halbleiterscheibe 5 zu vermeiden. Formbeständigkeit und Standzeit spielen dagegen bei der Feinschleifscheibe 2 keine so grosse Rolle, da beim Feinschleifen der Materialabtrag vergleichsweise gering ist.

Mit dem Feinschleifen wird die Randfläche der Halbleiterscheibe so nachgearbeitet, dass nur noch geringe Fehler im Halbleiterkristall vorhanden sind, die in einem späteren Aetzvorgang vollständig beseitigt werden können.

Auf den Feinschleifvorgang folgt schliesslich der eigentliche Schliff der Hohlkehle 8 (Fig. 3). Dieser Schliff wird in einem einzigen Arbeitsgang mit einer Profilschleifscheibe 3 durchgeführt, die am Rand der Hohlkehlenform entsprechend konturiert ist. Es versteht sich von selbst, dass bei diesem Schleifvorgang die Halbleiterscheibe 5 keine oszillatorische Querbewegung ausführt. Die Vorschubgeschwindigkeit beträgt hier ebenfalls 1 mm/min. Bei der Profilschleifscheibe 3 handelt es sich wiederum um eine Diamantschleifscheibe, die Diamantkörner mit einem mittleren Durchmesser von 16 $\mu$m in einer Metallbindung enthält. Die Metallbindung wird hier wieder gewählt, um bei dem relativ grossen Materialabtrag in der Hohlkehle eine ausreichende Standzeit der Schleifscheibe zu erreichen und vor allem auch die notwendige Formbeständigkeit der Kontur zu gewährleisten.

Die Anordnung aller drei Schleifscheiben 1,2 und 3 auf der gemeinsamen Schleifscheibenachse 4 hat den Vorteil, dass eine hohe Massgenauigkeit bei der Bearbeitung erzielt werden kann. Als günstig hat sich weiterhin für alle Schleifscheiben eine Belegungsdichte mit Diamantkörnern von etwa 4,4 Karat/cm$^3$ erwiesen.

Das erfindungsgemässe Verfahren wurde eingehend an Halbleiterscheiben für Thyristoren mit Sperrspannungen von 4400 bzw. 8000 V erprobt. Die entsprechende Dicke der Halbleiterscheiben betrug dabei 940 $\mu$m bzw. 1000 $\mu$m. Es werden dabei Diamantschleifscheiben verwendet, die unter dem Handelsnamen "Superfix" z.B. von der Firma Diametal AG, CH-2500 Biel/Schweiz bezogen werden können. Um die Bedeutung des speziellen Feinschliffs zu zeigen, wurden die Halbleiterscheiben teilweise mit Feinschleifscheiben mit Metallbindung und teilweise mit Feinschleifscheiben mit Kunststoffbindung nachbearbeitet. Es ergaben sich folgende Ausbeuten:

## 4400 V-Elemente:

|  | insgesamt | davon sperrend |
|---|---|---|
| Feinschliff m. Metallbindung | 10 | 0 |
| Feinschliff m. Kunststoffbindung | 60 | 42 |

## 8000 V-Elemente:

|  | insgesamt | davon sperrend |
|---|---|---|
| Feinschliff m. Kunststoffbindung | 17 | 16 |

Diese Ergebnisse zeigen deutlich die Wichtigkeit des Feinschliffvorganges für die Ausbeute der funktionstüchtigen, d.h. sperrenden Bauelementen.

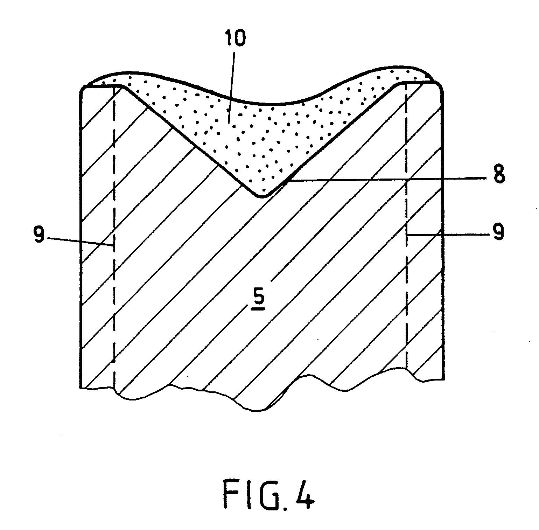

Nach den beschriebenen Schleifprozeduren werden die Halbleiterscheiben in üblicher Weise geätzt und passiviert. Der Querschnitt durch den Randbereich eines solchen fertigen 8000 V-Elements ist in Fig. 4 dargestellt. Man erkennt klar die Form der Hohlkehle 8 mit der darüberliegenden Randpassivierung 10. Gestrichelt angedeutet ist die Lage des entscheidenden pn-Uebergangs 9.

Insgesamt steht mit der Erfindung ein Verfahren zur Herstellung von Hohlkehlen in hochsperrenden Halbleiter-Bauelementen zur Verfügung, das einfach durchzuführen ist, eine gute Ausbeute und reproduzierbare Ergebnisse liefert.

**Ansprüche**

1. Verfahren zum Anbringen einer umlaufenden Hohlkehle (8) am Rand einer Halbleiterscheibe (5) eines Leistungshalbleiter-Bauelements, bei welchem die Hohlkehle (8) mechanisch in die Halbleiterscheibe eingeschliffen (5) wird, dadurch gekennzeichnet, dass

(a) der Rand der Halbleiterscheibe (5) zunächst plan geschliffen wird, wobei in einem ersten Schritt mit einer Grobschleifscheibe (1) überflüssiges Halbleitermaterial abgetragen, und in einem zweiten Schritt mit einer Feinschleifscheibe (2) die entstandene Randfläche nachgearbeitet wird;

(b) die Hohlkehle (8) dann mittels einer am Rand entsprechend konturierten Profilschleifscheibe (3) in einem Arbeitsgang eingeschliffen wird;

(c) für alle Schleifvorgänge Diamantschleifscheiben verwendet werden;

(d) bei der Grobschleifscheibe (1) und der Profilschleifscheibe (3) die Diamantkörner in einer Metallbindung vorliegen; und

(e) bei der Feinschleifscheibe (2) die Diamantkörner in einer Kunststoffbindung eingelagert sind.

2. Verfahren nach Anspruch 1, dadurch gekennzeichnet, dass zur Kühlung während der Schleifvorgänge Wasser mit zugesetztem Rostschutzmittel benutzt wird.

3. Verfahren nach Anspruch 1, dadurch gekennzeichnet, dass

(a) die Belegungsdichte mit Diamantkörnern bei allen Schleifscheiben etwa 4,4 Karat/cm$^3$ beträgt; und

(b) die Grobschleifscheibe (1) Diamantkörner mit einem mittleren Durchmesser von 25 $\mu$m, die Feinschleifscheibe (2) Diamantkörner mit einem mittleren Durchmesser von 20 $\mu$m und die Profilschleifscheibe (3) Diamantkörner mit einem mittleren Durchmesser von 16 $\mu$m enthält.

4. Verfahren nach Anspruch 1, dadurch gekennzeichnet, dass alle Schleifscheiben (1,2,3) auf einer gemeinsamen Schleifscheibenachse (4) angeordnet sind.

5. Verfahren nach Anspruch 3, dadurch gekennzeichnet, dass die Schleifvorgänge mit einer Schnittgeschwindigkeit von etwa 35 m/s durchgeführt werden.

6. Verfahren nach Anspruch 5, dadurch gekennzeichnet, dass

(a) die Halbleiterscheibe (5) bei den Schleifvorgängen zu den Schleifscheiben (1,2,3) gegenläufig rotiert; und

(b) die Rotation der Halbleiterscheibe (5) etwa 80 Umdrehungen/min beträgt.

7. Verfahren nach Anspruch 1, dadurch gekennzeichnet, dass die Halbleiterscheibe (5) beim Planschleifen parallel zur Rotationsachse bis über den Rand der jeweiligen Schleifscheibe (1,2) oszillatorisch hin- und herbewegt wird.

8. Verfahren nach Anspruch 1, dadurch gekennzeichnet, dass der Vorschub der Halbleiterscheibe (5) in Richtung auf die Schleifscheiben beim Grobschleifen etwa 3 mm/min und beim Fein- und Hohlkehlenschleifen etwa 1 mm/min beträgt.

**Claims**

1. Method of making an encircling groove (8) on the edge of a semiconductor slice (5) of a power semiconductor component in which the groove (8) is mechanically ground into the semiconductor slice (5), characterised in that

a) the edge of the semiconductor slice (5) is first of all surface-ground, surplus semiconductor material being removed in a first step with a rough-grinding wheel, and the edge surface which has developed being finish-machined in a second step with a precision-grinding wheel;

b) the groove (8) is then ground in in one operation by means of a form-grinding wheel (3) correspondingly contoured on the edge;

c) diamond grinding wheels are used for all grinding operations;

d) in the rough-grinding wheel and the form-grinding wheel the diamond grains are present in a metal bond; and

e) in the precision-grinding wheel the diamond grains are embedded in a synthetic bond.

2. Method according to Claim 1, characterised in that water with added rust preventative is used for cooling during the grinding operations.

3. Method according to Claim 1, characterised in that
   a) the diamond grain concentration in all grinding wheels is about 4.4 carats/cm$^3$; and
   b) the rough-grinding wheel (1) contains diamond grains with an average diameter of 25 $\mu$m, the precision-grinding wheel (2) contains diamond grains with an average diameter of 20 $\mu$m and the form-grinding wheel (3) contains diamond grains with an average diameter of 16 $\mu$m.

4. Method according to Claim 1, characterised in that all grinding wheels (1,2,3) are arranged on a common grinding-wheel spindle (4).

5. Method according to Claim 3, characterised in that the grinding operations are carried out at a cutting speed of about 35 m/s.

6. Method according to Claim 5, characterised in that
   a) the semiconductor slice (5) rotates in the opposite direction to the grinding wheels (1,2,3) during the grinding operations; and
   b) the rotation of the semiconductor slice (5) is about 80 revolutions/min.

7. Method according to Claim 1, characterised in that the semiconductor slice (5), during the surface grinding, is moved oscillatorily in a reciprocating manner parallel to the axis of rotation beyond the edge of the respective grinding wheel (1,2).

8. Method according to Claim 1, characterised in that the feed of the semiconductor slice (5) toward the grinding wheels is about 3 mm/min during rough grinding and about 1 mm/min during precision and groove grinding.


**Revendications**

1. Procédé pour ménager une gorge de pourtour (8) dans la face de chant d'une tranche semi-conductrice (5) d'un composant semi-conducteur de puissance, dans lequel la gorge (8) est meulée (5) mécaniquement dans la tranche semi-conductrice, caractérisé en ce que :
   (a) le chant de la tranche semi-conductrice (5) est tout d'abord rectifié à plat, c'est-à-dire que, dans un premier stade, l'excédent de matière semi-conductrice est enlevé au moyen d'une meule dégrossisseuse (1) et que, dans un second stade, la face de chant formée est rectifiée au moyen d'une meule finisseuse (2);
   (b) la gorge (8) est alors ménagée par meulage en une seule opération au moyen d'une meule de profilage (3) dont le chant est profilé de manière correspondante;
   (c) des meules diamantées sont utilisées pour toutes les opérations de meulage;
   (d) dans la meule dégrossisseuse (1) et la meule de profilage (3), les grains de diamant sont présents dans un liant métallique; et
   (e) dans la meule finisseuse (2), les grains de diamant sont implantés dans un liant en matière synthétique.

2. Procédé suivant la revendication 1, caractérisé en ce que de l'eau additionnée d'un inhibiteur de rouille est utilisée pour le refroidissement pendant les opérations de meulage.

3. Procédé suivant la revendication 1, caractérisé en ce que :
   (a) la densité de garnissage en grains de diamant de toutes les meules est d'environ 4,4 carats/cm$^3$; et
   (b) la meule dégrossisseuse (1) contient des grains de diamant d'un diamètre moyen de 25 $\mu$m, la meule finisseuse (2) contient des grains de diamant d'un diamètre moyen de 20 $\mu$m et la meule de profilage (3) contient des grains de diamant d'un diamètre moyen de 16 $\mu$m.

4. Procédé suivant la revendication 1, caractérisé en ce que toutes les meules (1, 2, 3) sont montées sur un arbre porte-meules (4) commun.

5. Procédé suivant la revendication 3, caractérisé en ce que les opérations de meulage s'effectuent à une vitesse de coupe d'environ 35 m/s.

6. Procédé suivant la revendication 5, caractérisé en ce que :
   (a) la tranche semi-conductrice (5) et les meules (1, 2, 3) tournent en sens opposé pendant les opérations de meulage, et
   (b) la tranche semi-conductrice (5) tourne à environ 80 tours/min.

7. Procédé suivant la revendication 1, caractérisé en ce que, pendant le meulage à plat, la tranche semi-conductrice (5) est animée d'un mouvement de va-et-vient oscillant, parallèlement à l'axe de rotation, jusqu'au-delà du bord de la meule (1, 2) en question.

8. Procédé suivant la revendication 1, caractérisé en ce que l'avancement de la tranche semi-conductrice (5) en direction des meules est d'environ 3 mm/min pour le dégrossissage et d'environ 1 mm/min, pour le meulage fin et le meulage de la gorge.

FIG.1

FIG. 2

FIG. 3

FIG. 4